# EUROPÄISCHE PATENTANMELDUNG

(11) **EP 3 534 278 A1**
(43) Veröffentlichungstag der Anmeldung: **04.09.2019**
(21) Anmeldenummer: 18159206.4
(22) Anmeldetag: 28.02.2018
(51) Int. Cl.: G06F 17/50

(54) **VERFAHREN UND ANORDNUNG ZUM RECHNERGESTÜTZTEN ENTWERFEN EINER INDUSTRIELLEN FERTIGUNGSANLAGE**

(71) Anmelder: Siemens Aktiengesellschaft, 80333 München (DE)
(72) Erfinder: Fischer, Jan, 81541 München (DE); Malik, Vincent, 80636 München (DE); Wehrstedt, Jan Christoph, 81829 München (DE); Weinert, Nils, 80798 München (DE)

(57) **Zusammenfassung**

Erfindungsgemäß werden für eine jeweilige Komponente (K1, K2) des technischen Systems (TS) eine Komponentenbezeichnung (KB1, KB2) sowie eine Kennparameterbezeichnung (KPB1, KPB2) für einen entwurfsrelevanten Kennparameter der Komponente (K1, K2) eingelesen und damit eine Suchmaschine (SE) angesteuert. Die von der Suchmaschine (SE) gefundenen Dokumente (D1, D2) werden eingelesen und daraus Komponentenangaben (KA1, KA2), z.B. Produktinformation über eine jeweilige Komponente, extrahiert. Die extrahierten Komponentenangaben (KA1, KA2) werden einer maschinellen Lernroutine (NN) zugeführt, die anhand einer Vielzahl von vorgegebenen Trainings-Komponentenangaben (TKA) und Trainings-Kennparameterwerten (TKPW) darauf trainiert wurde, vorgegebene Trainings-Kennparameterwerte (TKPW) anhand von vorgegebenen Trainings-Komponentenangaben (TKA) zu reproduzieren. Ausgabedaten (OUT) der maschinellen Lernroutine (NN) werden als Kennparameterwerte (KPW1, KPW2) selektiert und in einen Planungsdatensatz (PR1, PR2) eingefügt. Der Planungsdatensatz (PR1, PR2) wird dann zum Entwerfen des technischen Systems (TS) ausgegeben.

## Beschreibung

Zum Entwerfen von komplexen technischen Systemen, z.B. Fertigungsanlagen, Stromnetzen, Windturbinen, Gasturbinen, Kraftwerken, Robotern, Industrieanlagen oder Kraftfahrzeugen werden im zunehmenden Maße rechnergestützte Entwurfs- und Planungsinstrumente eingesetzt. Zu diesem Zweck sind die zu verbauenden Systemkomponenten als formalisierte Planungskomponenten eines Planungsmodells abzubilden. Dies kann sich jedoch insbesondere bei komplexen Systemen als sehr aufwendig erweisen, insofern eine jeweilige Komponente häufig von einer Vielzahl von Herstellern angeboten und in unterschiedlicher, nicht formalisierter Weise spezifiziert wird.

Es ist Aufgabe der vorliegenden Erfindung, ein Verfahren, eine Anordnung, ein Computerprogrammprodukt sowie ein computerlesbares Speichermedium anzugeben, durch die sich ein Aufwand beim Entwerfen eines technischen Systems verringern lässt.

Gelöst wird diese Aufgabe durch ein Verfahren mit den Merkmalen des Patentanspruchs 1, durch eine Anordnung mit den Merkmalen des Patentanspruchs 13, durch ein Computerprogrammprodukt mit den Merkmalen des Patentanspruchs 14 sowie durch ein computerlesbares Speichermedium mit den Merkmalen des Patentanspruchs 15.

Erfindungsgemäß werden zum rechnergestützten Entwerfen eines technischen Systems für eine jeweilige Komponente des technischen Systems eine Komponentenbezeichnung sowie eine Kennparameterbezeichnung für einen entwurfsrelevanten Kennparameter der Komponente eingelesen, eine Suchmaschine mit der eingelesenen Komponentenbezeichnung und/oder Kennparameterbezeichnung als Suchbegriff angesteuert und von der Suchmaschine gefundene Dokumente eingelesen. Eine jeweilige Kennparameterbezeichnung kann hierbei insbesondere angeben, welcher Kennparameter der jeweiligen Komponente für einen konkreten Entwurf des technischen Systems festzulegen ist. Aus den gefundenen Dokumenten werden Komponentenangaben, z.B. Produktinformation über eine jeweilige Komponente, extrahiert und einer maschinellen Lernroutine zugeführt, die anhand einer Vielzahl von vorgegebenen Trainings-Komponentenangaben und Trainings-Kennparameterwerten darauf trainiert wurde, vorgegebene Trainings-Kennparameterwerte anhand von vorgegebenen Trainings-Komponentenangaben zu reproduzieren. Weiterhin wird ein Planungsdatensatz für das technische System generiert, wobei Ausgabedaten der maschinellen Lernroutine als Kennparameterwerte selektiert und in den Planungsdatensatz eingefügt werden. Der Planungsdatensatz wird dann zum Entwerfen des technischen Systems ausgegeben.

Zur Durchführung des erfindungsgemäßen Verfahrens sind eine Anordnung, insbesondere ein Assistenzsystem zum rechnergestützten Entwerfen des technischen Systems, ein Computerprogrammprodukt sowie ein computerlesbares Speichermedium vorgesehen.

Das erfindungsgemäße Verfahren und die erfindungsgemäße Anordnung können beispielsweise mittels eines oder mehrerer Prozessoren, anwendungsspezifischer integrierter Schaltungen (ASIC), digitaler Signalprozessoren (DSP) und/oder sogenannter "Field Programmable Gate Arrays" (FPGA) ausgeführt bzw. implementiert werden.

Ein Vorteil der Erfindung ist insbesondere darin zu sehen, dass Planungsdatensätze weitgehend automatisch parametrisiert werden können. Derartige parametrisierte Planungsdatensätze können dann häufig direkt in Datenmodelle von automatisierten Planungsverfahren eingebunden werden. Darüber hinaus kann durch die Einbeziehung einer Suchmaschine weitgehend umfassende Information über verfügbare Komponenten und deren Kennparameter für den Entwurf berücksichtigt werden. Dies vergrößert in der Regel einen Optimierungsspielraum und führt mithin in vielen Fällen zu besseren Planungsergebnissen.

Vorteilhafte Ausführungsformen und Weiterbildungen der Erfindung sind in den abhängigen Ansprüchen angegeben.

Vorteilhafterweise kann die maschinelle Lernroutine mittels eines künstlichen neuronalen Netzes, eines rekurrenten neuronalen Netzes, eines faltenden neuronalen Netzes, eines Autoencoders, einer Deep-Learning-Architektur, einer Support-Vector-Machine, eines datengetriebenen trainierbaren Regressionsmodells, eines k-nächste-Nachbarn-Klassifikators, eines physikalischen Modells und/oder eines Entscheidungsbaumes implementiert sein. Zum Trainieren einer so implementierten maschinellen Lernroutine kann eine Vielzahl von effizienten Standardverfahren verwendet werden.

Nach einer vorteilhaften Ausführungsform der Erfindung kann ein Zielwert für einen für das technische System vorgegebenen Entwurfsparameter eingelesen werden und die Selektion der Kennparameterwerte abhängig vom eingelesenen Zielwert erfolgen. Der Entwurfsparameter kann hierbei eine vorgegebene Anforderung, Funktion, Randbedingung oder andere Eigenschaft des technischen Systems oder einer Komponente betreffen und/oder quantifizieren. Insbesondere kann der Entwurfsparameter betriebs-, funktions- oder produktionsrelevante Eigenschaften wie Lieferzeiten, Wartungszyklen etc. betreffen. Als Zielwert kann ein erwünschter oder geforderter Wert oder Wertebereich für den Entwurfsparameter eingelesen werden. Bei der Selektion kann insbesondere ein dem Zielwert nächstgelegener oder nahegelegener Kennparameterwert selektiert werden. Alternativ oder zusätzlich können Kennparameterwerte selektiert werden, die den Zielwert nicht über- oder unterschreiten.

Weiterhin kann mittels des generierten Planungsdatensatzes ein Simulator des technischen Systems konfiguriert werden. Mittels des konfigurierten Simulators kann dann eine technische Funktion des technischen Systems simuliert und eine Funktionsangabe über die simulierte technische Funktion ausgegeben werden. Der Simulator kann beispielsweise eine ereignisbasierte und/oder zeitdiskrete Simulation, insbesondere eine Logistiksimulation ausführen. Als technische Funktion kann insbesondere eine Betriebsfunktion des technischen Systems oder eines Teils davon, z.B. eine Leistung, eine Geschwindigkeit, ein Materialtransport, eine Ausbeute oder eine andere Fähigkeit oder Eigenschaft simuliert werden. Insbesondere können die in den Planungsdatensatz einzufügenden Kennparameterwerte derart selektiert werden, dass eine Abweichung der Funktionsangabe von einer für das technische System vorgegebenen Funktionsanforderung reduziert wird. Auf diese Weise kann die Funktion des technischen Systems an die Funktionsanforderung angepasst und/oder die Funktion optimiert werden

Gemäß einer weiteren vorteilhaften Ausführungsform der Erfindung kann eine Vielzahl von Planungsdatensätzen mit jeweils unterschiedlich aus Ausgabedaten der maschinellen Lernroutine selektierten Kennparameterwerten generiert werden. Für einen jeweils generierten Planungsdatensatz kann mittels eines Simulators eine technische Funktion des technischen Systems simuliert werden. Aus der Vielzahl der generierten Planungsdatensätze kann dann ein die simulierte technische Funktion optimierender Planungsdatensatz zum Entwerfen des technischen Systems ausgewählt werden.

Nach einer vorteilhaften Weiterbildung der Erfindung kann für eine jeweilige Komponente eine Komponententypangabe eingelesen werden. Die extrahierten Komponentenangaben können dann zusammen mit einer jeweiligen Komponententypangabe einer komponententypspezifsch trainierten maschinellen Lernroutine zugeführt werden. Als Komponententypangabe kann beispielsweise "Produktionsmaschine" oder "Transportsystem" vorgesehen sein. Ein komponententypspezifsches Training erweist sich in vielen Fällen als sehr effizient, da die Zuordnung von Kennparameterbezeichnungen zu Kennparameterwerten häufig typspezifisch ausgeprägt ist.

Ferner kann vorgesehen sein, dass die maschinelle Lernroutine anhand einer Vielzahl von vorgegebenen Trainings-Komponentenangaben, Trainings-Kennparameterbezeichnungen und Trainings-Kennparameterwerten darauf trainiert wurde, vorgegebene Trainings-Kennparameterwerte anhand von vorgegebenen Trainings-Komponentenangaben und Trainings-Kennparameterbezeichnungen zu reproduzieren. Der maschinellen Lernroutine können dann die Kennparameterbezeichnungen in Zuordnung zu den extrahierten Komponentenangaben zugeführt werden. Eine explizite Berücksichtigung der Trainings-Kennparameterbezeichnungen beim Training der maschinellen Lernroutine sowie der Kennparameterbezeichnungen bei der Anwendung der trainierten maschinellen Lernroutine kann in vielen Fällen eine Bestimmung der Kennparameterwerte erheblich verbessern.

Vorteilhafterweise kann die Suchmaschine einen auf Produktdaten fokussierten Webcrawler zum Durchsuchen eines Datennetzwerks, insbesondere des Internets oder eines Intranets verwenden. Ein fokussierter Webcrawler kann besuchte Seiten thematisch klassifizieren und seine Indexierung auf thematisch einschlägige Seiten einschränken. Auf diese Weise kann ein Anteil relevanter Dokumente unter den gefundenen Dokumenten in vielen Fällen erhöht werden.

Nach einer weiteren vorteilhaften Ausführungsform der Erfindung können die Komponentenangaben mittels eines Parsers, z.B. eines HTML- oder XML-Parsers, und/oder eines Mustererkenners aus den gefundenen Dokumenten extrahiert werden.

Weiterhin kann eine jeweilige Komponentenbezeichnung und/oder Kennparameterbezeichnung aus einem Bauplan des technischen Systems eingelesen werden. Als Bauplan kann insbesondere ein elektronischer Bauplan, z.B. ein CAD-Planungsentwurf für das technische System verwendet werden.

Darüber hinaus kann die Vielzahl von Trainings-Kennparameterwerten aus einer Vielzahl von parametrisierten Planungsdatensätzen extrahiert werden. Unter einem parametrisierten Planungsdatensatz ist insbesondere ein Planungsdatensatz mit eingesetzten, vorzugsweise einheitlich formalisierten Kennparameterwerten zu verstehen. Geeignete parametrisierte Planungsdatensätze stehen häufig von früher fertiggestellten Entwürfen von technischen Systemen zur Verfügung oder können daraus abgeleitet werden. Vorzugsweise können parametrisierte Planungsdatensätze von ähnlichen technischen Systemen verwendet werden. In vielen Fällen können aber auch parametrisierte Planungsdatensätze von unterschiedlichen technischen Systemen nutzbringend verwendet werden, da häufig systemübergreifende Korrelationen zwischen Komponentenbezeichnungen, Kennparameterbezeichnungen und Kennparameterangaben bestehen, die von einer maschinellen Lernroutine gelernt werden können.

Ein Ausführungsbeispiel der Erfindung wird nachfolgend anhand der Zeichnung näher erläutert. Dabei zeigen jeweils in schematischer Darstellung
- Figur 1: ein erfindungsgemäßes Assistenzsystem zum Entwerfen eines technischen Systems in einer Trainingsphase des Assistenzsystems und
- Figur 2: das trainierte Assistenzsystem in einer Anwendungs-phase.

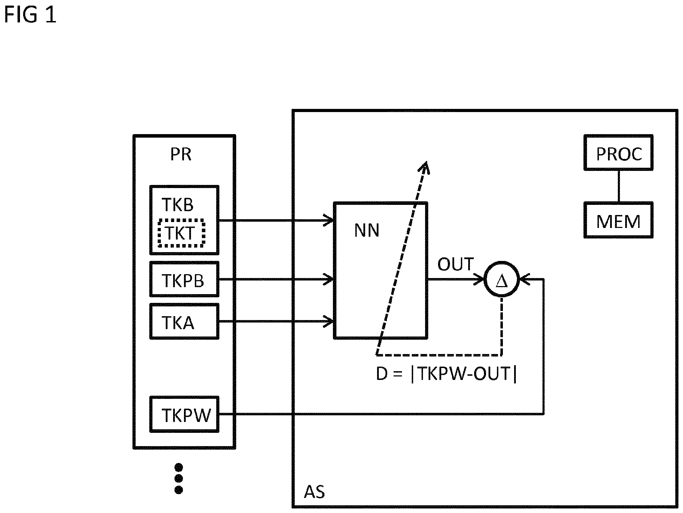

Figur 1 zeigt ein in einer Trainingsphase befindliches Assistenzsystem AS zum Entwerfen eines technischen Systems in schematischer Darstellung. Durch das Assistenzsystem AS können eine Vielzahl von technischen Systemen entworfen werden, wie z.B. Fertigungsanlagen, Stromnetze, Windturbinen, Gasturbinen, Kraftwerke, Roboter, Industrieanlagen, Kraftfahrzeuge oder Kombinationen hiervon. Die zu entwerfenden technischen Systeme umfassen dabei jeweils eine Vielzahl von verschiedenen technisch interagierenden Komponenten, wie beispielsweise elektrische oder mechanische Bauteile, Fertigungsroboter, Werkzeugmaschinen, Transportsysteme, Förderbänder und/oder andere Maschinen oder Maschinenteile.

Für den Entwurf ist insbesondere zu ermitteln, welche Komponenten mit welchen Eigenschaften für die Konstruktion des technischen Systems erforderlich und verfügbar sind. Die Komponenten können dabei von einer Vielzahl von Anbietern oder Herstellern stammen.

Zur Konkretisierung des Entwurfs sind für eine jeweilige Komponente konkrete Werte von Kennparametern dieser Komponente festzulegen oder anzupassen. Derartige komponentenspezifische Kennparameter quantifizieren die für den Entwurf eines technischen Systems relevanten Eigenschaften der jeweiligen Komponente, wie z.B. deren Abmessungen, deren Ressourcenverbrauch, deren Fähigkeiten und/oder deren Funktionen.

Anhand der ermittelten Kennparameterwerte können dann z.B. unparametrisierte Planungsmodelle parametrisiert werden und die parametrisierten Planungsmodelle zur Fertigung oder quantitativen Simulation des technischen Systems verwendet werden.

Ein solches unparametrisiertes Planungsmodell kann z.B. ein Bauplan oder ein anderes Planungsmodell sein, bei dem die Komponenten und deren entwurfsrelevante Kennparameter zwar bezeichnet, aber noch nicht quantifiziert sind, z.B. weil noch nicht bekannt ist, welche konkreten Kennparameterwerte die am Markt verfügbaren Komponenten aufweisen.

Das Assistenzsystem AS verfügt über einen oder mehrere Prozessoren PROC zum Ausführen der Verfahrensschritte des Assistenzsystems AS sowie über einen oder mehrere Speicher MEM zum Speichern von durch das Assistenzsystem AS zu verarbeitenden Daten.

Das Assistenzsystem AS umfasst erfindungsgemäß ein trainierbares, künstliches neuronales Netz NN, durch das eine maschinelle Lernroutine implementiert wird. Das neuronale Netz NN ist darauf zu trainieren, aus textuellen Angaben über eine Vielzahl von Komponenten von technischen Systemen Kennparameterwerte dieser Komponenten einheitlich formalisiert bzw. in einen einheitlichen maschinenlesbaren Format zu extrahieren.

Zum Training des neuronalen Netzes NN werden durch das Assistenzsystem AS eine Vielzahl von vorgegebenen parametrisierten Planungsdatensätzen PR für Komponenten, deren Kennparameterwerte bekannt sind, eingelesen. Die Planungsdatensätze PR können z.B. aus einem oder mehreren Komponentenkatalogen, Komponentenbibliotheken oder anderen Datenbanken eingelesen werden. Vorzugsweise werden hierbei Planungsdatensätze PR von Komponenten eingelesen, die auch für das zu entwerfende technische System oder für ähnliche technische Systeme verwendbar sind.

Die Planungsdatensätze PR umfassen insbesondere auch formalisierte Parametrisierungen der betreffenden Komponenten; das heißt deren Kernparameterwerte liegen einheitlich formalisiert in den Planungsdatensätzen PR vor.

Aus den Planungsdatensätzen PR werden eine Vielzahl von Trainings-Komponentenbezeichnungen TKB extrahiert. Die Trainings-Komponentenbezeichnungen TKB bezeichnen jeweils eine Komponente und können z.B. die Bezeichnungen "Roboter" oder "Transportband" umfassen. Weiterhin umfasst eine jeweilige Trainings-Komponentenbezeichnung TKB eine Trainings-Komponententypangabe TKT, z.B. in Form der Bezeichnung "Produktionsmaschine" oder "Transportsystem". Weiterhin werden aus den Planungsdatensätzen PR für eine jeweilige Komponente Trainings-Kennparameterbezeichnungen TKPB extrahiert, die für einen konkreten Entwurf festzulegende Kennparameter der jeweiligen Komponente bezeichnen. Als Trainings-Kennparameterbezeichnungen TKPB können z.B. die Bezeichnungen "Länge", "Breite", "Gewicht", "Positioniergenauigkeit", "Fördergeschwindigkeit", "Leitungsquerschnitt", "Rohrreibungswert", "Tankvolumen" oder "Wartungsintervall" verwendet werden.

Weiterhin werden aus den Planungsdatensätzen PR eine Vielzahl von Trainings-Komponentenangaben TKA extrahiert, die textuelle Angaben über eine jeweilige Komponente, z.B. Produktinformation aus einer Webseite eines Herstellers oder aus einem Komponentenkatalog oder einer Komponentenbibliothek umfassen. Diese textuellen Angaben enthalten insbesondere quantifizierte Werte von Kennparametern einer jeweiligen Komponente, allerdings in der Regel in nichtformalisierter Textform.

Wie oben bereits erwähnt, soll das neuronale Netz NN darauf trainiert werden, diese in nichtformalisierter Textform enthaltenen Kennparameterwerte in einem einheitlichen maschinenlesbaren Format zu extrahieren. Zum Zwecke dieses Trainings liegen in den Planungsdatensätzen PR - wie oben bereits angedeutet - zusätzlich auch korrespondierende, einheitlich formalisierte Trainings-Kennparameterwerte TKPW vor. Die Trainings-Kennparameterwerte TKPW sind jeweils einer vorgegebenen Trainings-Komponentenbezeichnung TKB einer Trainings-Kennparameterbezeichnung TKPB sowie einer Trainings-Komponentenangabe TKA zugeordnet. Ein jeweiliger Trainings-Kennparameterwert TKPW gibt einen Wert oder einen Wertebereich eines durch die zugeordnete Trainings-Kennparameterbezeichnung TKPB bezeichneten Kennparameters in einheitlichem maschinenlesbarem Format an. So kann z.B. der Komponentenbezeichnung "Transportband" zusammen mit der Kennparameterbezeichnung "Länge" und der Komponentenangabe "Bauplan Transportband: [...] Länge: 10m" als Kennparameterwert die formalisierte Angabe "10m" zugeordnet werden. Derartige Komponentenangaben können beispielsweise mittels eines sogenannten regulären Ausdrucks aus den Planungsdatensätzen PR extrahiert werden.

Zum Training des neuronalen Netzes NN werden diesem zueinander korrespondierende Trainings-Komponentenbezeichnungen TKB, Trainings-Kennparameterbezeichnungen TKPB und Trainings-Komponentenangaben TKA als Eingabedaten übermittelt.

Unter Training sei hierbei allgemein eine Optimierung einer Abbildung von Eingabedaten einer maschinellen Lernroutine, hier implementiert mittels des neuronalen Netzes NN, auf Ausgabedaten verstanden. Diese Abbildung wird nach vorgegebenen, gelernten und/oder zu lernenden Kriterien während einer Trainingsphase optimiert. Als Kriterium kann hierbei insbesondere eine Abweichung zwischen gewünschten und tatsächlichen Ausgabedaten genutzt werden. Durch das Training können z.B. Gewichte von Verbindungen zwischen Neuronen des neuronalen Netzes NN oder deren Vernetzungsstruktur derart optimiert werden, dass die vorgegebenen Kriterien möglichst gut erfüllt werden.

Im vorliegenden Ausführungsbeispiel wird durch das Training angestrebt, dass durch das neuronale Netz NN aus den Eingabedaten abgeleitete Ausgabedaten OUT möglichst genau die korrespondierenden formalisierten Trainings-Kennparameterwerte TKPW reproduzieren.

Zu diesem Zweck werden die Ausgabedaten OUT mit den zum Assistenzsystem AS übermittelten und den Eingabedaten TKB, TKPB und TKA jeweils zugeordneten Trainings-Kennparameterwerten TKPW verglichen. Im Rahmen des Vergleichs wird eine Abweichung D, z.B. ein Absolutbetrag oder ein Quadrat einer Differenz, zwischen den Ausgabedaten OUT und den Trainings-Kennparameterwerten TKPW ermittelt. Die Abweichung D wird anschließend zum neuronalen Netz NN zurückgeführt. Anhand der zurückgeführten Abweichung D wird das neuronale Netz NN - wie durch einen strichlierten Pfeil angedeutet - darauf trainiert, die Abweichung D zu minimieren, d.h. die Trainings-Kennparameterwerte TKPW durch die aus den Eingabedaten abgeleiteten Ausgabedaten OUT möglichst gut zu reproduzieren. Mit anderen Worten das neuronale Netz NN wird darauf trainiert, mit den Ausgabedaten OUT einheitlich formalisierte Kennparameterwerte aus informalen Komponentenangaben zu extrahieren. Die Abweichung D repräsentiert hierbei einen Extraktionsfehler des neuronalen Netzes NN.

Durch die Berücksichtigung der Trainings-Komponententypangabe TKT erfolgt das Training im vorliegenden Ausführungsbeispiel komponententypspezifisch, d.h. spezifisch für den Typ einer jeweiligen Komponente. Alternativ oder zusätzlich kann das Training auch gruppenspezifisch für häufig verbaute Komponentengruppen oder Komponentenkombinationen durchgeführt werden.

Zum Training des neuronalen Netzes NN kann eine Vielzahl von Standardverfahren des maschinellen Lernens, insbesondere des überwachten Lernens eingesetzt werden.

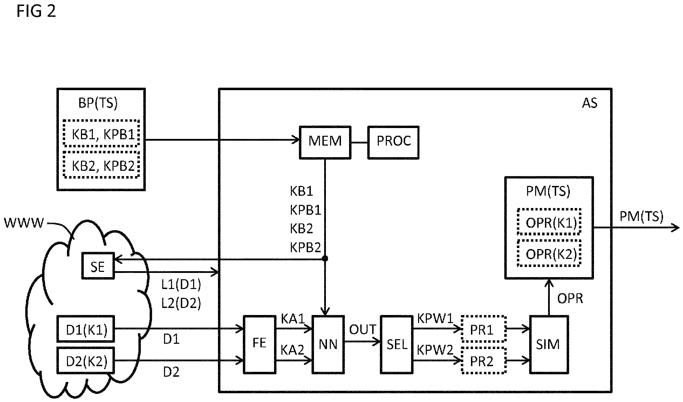

Figur 2 zeigt in schematischer Darstellung das trainierte Assistenzsystem AS in einer Anwendungsphase, d.h. beim Entwerfen eines konkreten technischen Systems TS. Insofern in Figur 2 die gleichen Bezugszeichen wie in Figur 1 verwendet werden, bezeichnen diese Bezugszeichen die gleichen Entitäten. Diese Entitäten können im Funktionszusammenhang von Figur 2 wie im Zusammenhang mit Figur 1 beschrieben implementiert oder realisiert werden.

Das Assistenzsystem AS soll im vorliegenden Ausführungsbeispiel zum Entwerfen einer Fertigungsanlage als technisches System TS dienen. Alternativ oder zusätzlich kann das zu konstruierende technische System auch ein Stromnetz, eine Windturbine, eine Gasturbine, ein Kraftwerk, ein Roboter, eine Industrieanlage oder ein Kraftfahrzeug sein oder eine solche Anordnung umfassen.

Zum Entwerfen der Fertigungsanlage TS soll durch das trainierte Assistenzsystem AS ein die Fertigungsanlage TS spezifizierendes Planungsmodell PM anhand eines Bauplans BP der Fertigungsanlage TS generiert werden.

Die zu entwerfende Fertigungsanlage TS umfasst eine Vielzahl von verschiedenen, technisch interagierenden Komponenten. Von diesen Komponenten werden in Figur 2 aus Übersichtlichkeitsgründen beispielhaft nur zwei Komponenten K1 und K2 der Fertigungsanlage TS explizit referenziert. Die Komponenten K1 und K2 können beispielsweise Fertigungsroboter, Werkzeugmaschinen, Transportsysteme, Förderbänder oder andere Maschinen oder Maschinenteile sein. Eigenschaften der Komponenten K1 und K2 werden jeweils durch deren Kennparameter, wie oben dargelegt, charakterisiert.

Durch den Bauplan BP wird ein grundsätzlicher Aufbau der Fertigungsanlage TS aus den verschiedenen Komponenten, hier K1 und K2, sowie deren Funktionszusammenhang beschrieben. Der Bauplan BP ist jedoch noch nicht parametrisiert, d.h. er enthält zwar Komponentenbezeichnungen KB1 und KB2 der Komponenten K1 und K2 sowie Kennparameterbezeichnungen KPB1 und KPB2 von Kennparametern der Komponenten K1 und K2, aber noch nicht oder noch nicht vollständig die konkreten Werte dieser Parameter. Wie oben bereits erwähnt können die Komponentenbezeichnungen KB1 und KB2 Bezeichnungen, wie z.B. "Roboter" oder "Transportband" umfassen. Darüber hinaus umfassen im vorliegenden Ausführungsbeispiel die Komponentenbezeichnungen KB1 und KB2 jeweils eine Komponententypangabe, wie z.B. "Produktionsmaschine" oder "Transportsystem".

Wie oben bereits angedeutet, ist für den Entwurf mit Hilfe des Assistenzsystems AS zu ermitteln, welche Komponenten mit welchen Kennparameterwerten für die Konstruktion der Fertigungsanlage TS erforderlich und verfügbar sind.

Zu diesem Zweck werden durch das Assistenzsystem AS aus dem unparametrisierten Bauplan BP zunächst die Komponentenbezeichnungen KB1 und KB2 der erforderlichen Komponenten K1 und K2 sowie deren Kennparameterbezeichnungen KPB1 und KPB2 eingelesen und im Speicher MEM gespeichert.

Für eine jeweilige Komponente K1 und K2 wird dann eine Suchmaschine SE mit den eingelesenen Bezeichnungen KB1 und KPB1 bzw. KB2 und KPB2 als Suchbegriffe angesteuert. Hierbei werden die Suchbegriffe zur Suchmaschine SE übermittelt, die infolgedessen Verweise auf Dokumente zurückliefert, in denen die Suchbegriffe bevorzugt vorkommen. Aus Gründen der Übersichtlichkeit sind in Figur 2 beispielhaft nur zwei derartige Verweise L1 und L2 auf Dokumente D1 und D2 explizit referenziert. Als Suchmaschine SE kann eine externe oder interne Suchmaschine für ein Datennetzwerk WWW, wie das Internet oder das Intranet verwendet werden. Im vorliegenden Ausführungsbeispiel wird durch die Suchmaschine SE das World Wide Web als Datennetzwerk www durchsucht. Die gefundenen Dokumente D1 und D2 sind häufig Hypertext- oder pdf-Dokumente, die von Webseiten von Herstellern oder Anbietern einer jeweiligen Komponente K1 bzw. K2 stammen. Die Dokumente D1 und D2 enthalten in der Regel informale, herstellerspezifische Produktinformation über die betreffende Komponente K1 bzw. K2 in herstellerspezifischem Format.

Vorzugsweise umfasst oder verwendet die Suchmaschine SE zum Durchsuchen des Datennetzwerks WWW einen sogenannten Webcrawler, insbesondere einen auf Produktdaten fokussierten Webcrawler. Ein solcher Webcrawler klassifiziert Webseiten und Hyperlinks thematisch, hier hinsichtlich vorhandener Produktdaten, und schränkt seine Indexierung auf thematisch einschlägige Webseiten ein.

Die durch die Suchmaschine gefundenen Dokumente, hier D1 und D2 werden durch das Assistenzsystem AS aus dem Datennetzwerk WWW abgerufen und einer Merkmalsextraktion FE unterzogen. Die Merkmalsextraktion FE umfasst einen HTML- und/oder pdf-Parser, der einen Textinhalt aus den Dokumenten D1 und D2 extrahiert. Weiterhin verwendet die Merkmalsextraktion FE einen nachgeschalteten Mustererkenner, der spezifisch zur Erkennung von Textmustern und zur Extraktion von zugehörigem Textinhalt ausgestaltet ist. Ein solcher Mustererkenner kann beispielsweise mittels sogenannter regulärer Ausdrücke implementiert werden. Eine derartige Merkmalsextraktion FE wird häufig auch als Feature Extraction bezeichnet.

Im vorliegenden Ausführungsbeispiel werden durch die Merkmalsextraktion FE Textabschnitte in den Dokumenten D1 und D2 erkannt, die die Kennparameterbezeichnungen KPB1 und KPB2 enthalten. Aus den erkannten Textabschnitten wird anschließend jeweils eine der Kennparameterbezeichnung KPB1 bzw. KPB2 textlich zugeordnete Komponentenangabe KA1 bzw. KA2 extrahiert. Diese komponentenspezifischen, textuellen Komponentenangaben KA1 und KA2 der Hersteller enthalten in der Regel die quantifizierten Werte der Kennparameter der jeweiligen Komponente, allerdings in der Regel in nicht formalisierter Textform.

Für eine jeweilige Komponente K1 bzw. K2 werden die Bezeichnungen KB1 und KPB1 sowie die Komponentenangabe KA1 bzw. die Bezeichnungen KB2 und KPB2 und die Komponentenangabe KA2 einander zugeordnet zum trainierten neuronalen Netz NN als Eingabedaten übermittelt. Aus den Eingabedaten werden durch das trainierte neuronale Netz NN Ausgabedaten OUT abgeleitet. Die Ausgabedaten OUT werden vom neuronalen Netz NN zu einem Selektionsmodul SEL übermittelt, das aus den Ausgabedaten OUT komponentenspezifische und kennparameterspezifische Kennparameterwerte selektiert. Aus Gründen der Übersichtlichkeit sind in Figur 2 beispielhaft nur zwei Kennparameterwerte KPW1 und KPW2 explizit referenziert. Der Kennparameterwert KPW1 bzw. KPW2 gibt hierbei einen Wert oder Wertebereich eines durch die Kennparameterbezeichnung KPB1 bzw. KPB2 bezeichneten Kennparameters an.

Mittels des trainierten neuronalen Netzes NN können so aus informalen, herstellerspezifischen Dokumenten D1 und D2 einheitlich formalisierte Kennparameterwerte KPW1 und KPW2 planungsbezogen extrahiert werden.

Die Kennparameterwerte KPW1 und KPW2 werden jeweils in Zuordnung zur betreffenden Kennparameterbezeichnung KPB1 bzw. KPB2 in einen Planungsdatensatz PR1 bzw. PR2 für die betreffende Komponente K1, bzw. K2 eingefügt. Auf diese Weise wird der jeweilige Planungsdatensatz PR1 bzw. PR2 parametrisiert, d.h. für vorher noch unbestimmte Kennparameter werden konkrete Kennparameterwerte, hier KPW1 bzw. KPW2 in den jeweiligen Planungsdatensatz PR1 bzw. PR2 eingesetzt. Der Planungsdatensatz PR1 bzw. PR2 bildet damit gewissermaßen eine parametrisierte Instanz einer Planungskomponente.

Auf die vorstehend beschriebene Weise wird eine Vielzahl von parametrisierten Planungsdatensätzen für eine Vielzahl von durch die Suchmaschine SE gefundenen Dokumenten und einer Vielzahl von darin angegebenen Kennparameterwerten generiert.

Zur Ableitung eines optimierten, die Fertigungsanlage TS spezifizierenden Planungsmodells PM aus den generierten Planungsdatensätzen verfügt das Assistenzsystem AS über einen Simulator SIM. Der Simulator SIM simuliert anhand eines oder mehrerer parametrisierter Planungsdatensätze ein daraus resultierendes dynamisches Verhalten der Fertigungsanlage TS, ein Verhalten einer jeweiligen Komponente und/oder ein technisches Zusammenwirken von Komponenten. Die Simulation wird vorzugsweise jeweils für verschiedene, insbesondere typische und/oder vorgegebene Betriebssituationen durchgeführt. Der Simulator SIM umfasst zu diesem Zweck ein konfigurierbares Systemmodell der Komponenten und des technischen Zusammenwirkens der Komponenten.

Mittels des Simulators SIM werden für die Vielzahl der parametrisierten Planungsdatensätze jeweils eine oder mehrere technische Funktionen der Fertigungsanlage TS, z.B. ein Materialtransport und/oder eine Werkstückbearbeitung simuliert. Anschließend wird aus der Vielzahl der parametrisierten Planungsdatensätze ein diese technische Funktion optimierender, komponentenspezifischer Planungsdatensatz OPR ausgewählt und in das Planungsmodell PM eingefügt. Die vorstehende optimierende Auswahl wird vorzugsweise für jede der Komponenten und/oder spezifisch für jeden Komponententyp ausgeführt.

Auf diese Weise optimierte Planungsdatensätze und/oder Planungsmodelle können vorzugweise in einer planungsprojektübergreifenden Datenbank oder Planungsbibliothek gespeichert werden. Eine solche Datenbank oder Planungsbibliothek kann in vorteilhafter Weise für weitere Planungsprojekte genutzt werden.

Alternativ oder zusätzlich zur oben beschriebenen Auswahl von optimierenden Planungsdatensätzen OPR kann mittels des Simulators SIM auch die Selektion der Kennparameterwerte aus den Ausgabedaten OUT des neuronalen Netzes NN gesteuert werden. Die Selektion kann hierbei insbesondere abhängig von der kennparameterwertspezifisch simulierten technischen Funktion der Fertigungsanlage TS und deren Vergleich mit einer vorgegebenen Funktionsanforderung erfolgen. Als Funktionsanforderung kann hierbei z.B. eine für die Fertigungsanlage TS geforderte Fördergeschwindigkeit einer Förderbandkomponente, eine Positioniergenauigkeit einer Roboterkomponente, ein Ressourcenverbrauch und/oder ein anderer Zielwert für einen Entwurfsparameter vorgegeben sein.

Das so generierte, optimierte Planungsmodell PM umfasst eine Vielzahl von optimierenden parametrisierten Planungsdatensätzen OPR, die die Fertigungsanlage TS spezifizieren und zur Fertigung oder quantitativen Simulation einer dahingehend optimierten Fertigungsanlage TS verwendet werden können. Das optimierte Planungsmodell PM wird schließlich zum Entwerfen der Fertigungsanlage TS durch das Assistenzsystem AS ausgegeben.

Die Erfindung erlaubt eine weitgehend automatische Erzeugung von Instanzen von Planungskomponenten, die häufig direkt in Modelle von vorgegebenen Planungsmethoden eingebunden werden können. Durch eine automatisierte Einbeziehung einer Internetsuche mittels der Suchmaschine SE kann bei der Planung eine weitgehend umfassende Information über verfügbare Komponenten und deren Kennparameter berücksichtigt werden. Insbesondere kann durch die automatische Berücksichtigung mehrerer Lösungsalternativen in einer Planungsmethode häufig ein größerer Lösungsraum, z.B. im Rahmen von heuristischen Planungs-und/oder Optimierungsansätzen evaluiert werden. Dies vergrößert in der Regel einen Optimierungsspielraum und führt mithin in vielen Fällen zu besseren Planungsergebnissen.

## Patentansprüche

1. Verfahren zum rechnergestützten Entwerfen eines technischen Systems (TS), wobei
a) für eine jeweilige Komponente (K1, K2) des technischen Systems (TS)
- eine Komponentenbezeichnung (KB1, KB2) sowie eine Kennparameterbezeichnung (KPB1, KPB2) für einen entwurfsrelevanten Kennparameter der Komponente (K1, K2) eingelesen werden,
- eine Suchmaschine (SE) mit der eingelesenen Komponentenbezeichnung (KB1, KB2) und/oder Kennparameterbezeichnung (KPB1, KPB2) als Suchbegriff angesteuert wird,
- von der Suchmaschine (SE) gefundene Dokumente (D1, D2) eingelesen werden und daraus Komponentenangaben (KA1, KA2) extrahiert werden,
b) die extrahierten Komponentenangaben (KA1, KA2) einer maschinellen Lernroutine (NN) zugeführt werden, die anhand einer Vielzahl von vorgegebenen Trainings-Komponentenangaben (TKA) und Trainings-Kennparameterwerten (TKPW) darauf trainiert wurde, vorgegebene Trainings-Kennparameterwerte (TKPW) anhand von vorgegebenen Trainings-Komponentenangaben (TKA) zu reproduzieren,
c) ein Planungsdatensatz (PR1, PR2) für das technische System (TS) generiert wird, wobei Ausgabedaten (OUT) der maschinellen Lernroutine (NN) als Kennparameterwerte (KPW1, KPW2) selektiert und in den Planungsdatensatz (PR1, PR2) eingefügt werden, und
d) der Planungsdatensatz (PR1, PR2) zum Entwerfen des technischen Systems (TS) ausgegeben wird.

2. Verfahren nach Anspruch 1, **dadurch gekennzeichnet,**
**dass** die maschinelle Lernroutine mittels eines künstlichen neuronalen Netzes (NN), eines rekurrenten neuronalen Netzes, eines faltenden neuronalen Netzes, eines Autoencoders, einer Deep-Learning-Architektur, einer Support-Vector-Machine, eines datengetriebenen trainierbaren Regressionsmodells, eines k-nächste-Nachbarn-Klassifikators, eines physikalischen Modells und/oder eines Entscheidungsbaumes implementiert ist.

3. Verfahren nach einem der vorhergehenden Ansprüche, **dadurch gekennzeichnet,**
**dass** ein Zielwert für einen für das technische System vorgegebenen Entwurfsparameter eingelesen wird,
**dass** die Selektion der Kennparameterwerte (KPW1, KPW2) abhängig vom eingelesenen Zielwert erfolgt.

4. Verfahren nach einem der vorhergehenden Ansprüche, **dadurch gekennzeichnet,**
**dass** mittels des generierten Planungsdatensatzes (PR1, PR2) ein Simulator (SIM) des technischen Systems (TS) konfiguriert wird,
**dass** eine technische Funktion des technischen Systems (TS) mittels des konfigurierten Simulators (SIM) simuliert wird, und
**dass** eine Funktionsangabe über die simulierte technische Funktion ausgegeben wird.

5. Verfahren nach Anspruch 4, **dadurch gekennzeichnet,**
**dass** die in den Planungsdatensatz (PR1, PR2) einzufügenden Kennparameterwerte (KPW1, KPW2) derart selektiert werden, dass eine Abweichung der Funktionsangabe von einer für das technische System vorgegebenen Funktionsanforderung reduziert wird.

6. Verfahren nach einem der vorhergehenden Ansprüche, **dadurch gekennzeichnet,**
**dass** eine Vielzahl von Planungsdatensätzen (PR1, PR2) mit jeweils unterschiedlich aus Ausgabedaten (OUT) der maschinellen Lernroutine (NN) selektierten Kennparameterwerten (KPW1, KPW2) generiert wird,
**dass** für einen jeweils generierten Planungsdatensatz (PR1, PR2) eine technische Funktion des technischen Systems (TS) mittels eines Simulators (SIM) simuliert wird, und
**dass** aus der Vielzahl der generierten Planungsdatensätze (PR1, PR2) ein die simulierte technische Funktion optimierender Planungsdatensatz (OPR) zum Entwerfen des technischen Systems (TS) ausgewählt wird.

7. Verfahren nach einem der vorhergehenden Ansprüche, **dadurch gekennzeichnet,**
**dass** für eine jeweilige Komponente (K1, K2) eine Komponententypangabe eingelesen wird,
**dass** die maschinelle Lernroutine (NN) komponententypspezifisch trainiert wurde, und
**dass** die extrahierten Komponentenangaben (KA1, KA2) zusammen mit einer jeweiligen Komponententypangabe der maschinellen Lernroutine (NN) zugeführt werden.

8. Verfahren nach einem der vorhergehenden Ansprüche, **dadurch gekennzeichnet,**
**dass** die maschinelle Lernroutine (NN) anhand einer Vielzahl von vorgegebenen Trainings-Komponentenangaben (TKA), Trainings-Kennparameterbezeichnungen (TKPB) und Trainings-Kennparameterwerten (TKPW) darauf trainiert wurde, vorgegebene Trainings-Kennparameterwerte (TKPW) anhand von vorgegebenen Trainings-Komponentenangaben (TKA) und Trainings-Kennparameterbezeichnungen (TKPB) zu reproduzieren, und
**dass** der maschinellen Lernroutine (NN) die Kennparameterbezeichnungen (KPB1, KPB2) in Zuordnung zu den extrahierten Komponentenangaben (KA1, KA2) zugeführt werden.

9. Verfahren nach einem der vorhergehenden Ansprüche, **dadurch gekennzeichnet,**
**dass** die Suchmaschine (SE) einen auf Produktdaten fokussierten Webcrawler zum Durchsuchen eines Datennetzwerks (WWW) verwendet.

10. Verfahren nach einem der vorhergehenden Ansprüche, **dadurch gekennzeichnet,**
**dass** die Komponentenangaben (KA1, KA2) mittels eines Parsers und/oder eines Mustererkenners aus den gefundenen Dokumenten (D1, D2) extrahiert werden.

11. Verfahren nach einem der vorhergehenden Ansprüche, **dadurch gekennzeichnet,**
**dass** eine jeweilige Komponentenbezeichnung (KB1, KB2) und/oder Kennparameterbezeichnung (KPB1, KPB2) aus einem Bauplan (BP) des technischen Systems (TS) eingelesen wird.

12. Verfahren nach einem der vorhergehenden Ansprüche, **dadurch gekennzeichnet,**
**dass** die Vielzahl von Trainings-Kennparameterwerten (TKPW) aus einer Vielzahl von parametrisierten Planungsdatensätzen (PR) extrahiert wird.

13. Anordnung (AS) zum rechnergestützten Entwerfen eines technischen Systems (TS), eingerichtet zum Ausführen eines Verfahrens nach einem der vorhergehenden Ansprüche.

14. Computerprogrammprodukt eingerichtet zum Ausführen eines Verfahrens nach einem der Ansprüche 1 bis 12.

15. Computerlesbares Speichermedium mit einem Computerprogrammprodukt nach Anspruch 14.
